# EUROPEAN PATENT SPECIFICATION

(11) **EP 3 244 216 B1**
(45) Date of publication and mention of the grant of the patent: **21.11.2018**
(21) Application number: 15876899.4
(22) Date of filing: 12.06.2015
(51) Int. Cl.: G01R 15/20

(54) **CURRENT DETECTOR**
STROMSENSOR
CAPTEUR DE COURANT

(30) Priority: 07.01.2015 JP 2015001396
(43) Date of publication of application: 15.11.2017
(73) Proprietor: Sinfonia Technology Co., Ltd., Tokyo 105-8564 (JP)
(72) Inventor: MATSUI, Takashi, Tokyo 105-8564 (JP)
(74) Representative: Hinkelmann, Klaus
(86) International application number: PCT/JP2015/066991
(87) International publication number: WO 2016/111026

(56) References cited:
- EP-A1- 2 660 611
- EP-A1- 2 741 091
- JP-A- H07 260 829
- JP-A- H07 260 829
- JP-A- 2013 120 106
- JP-A- 2013 120 106
- JP-A- 2013 164 288
- JP-A- 2013 164 288

## Description

### TECHNICAL FIELD

The present invention relates to a current detector.

### BACKGROUND ART

What is conventionally known is a current detector that has a magnetic core and a magnetoelectric transducer (a Hall effect sensor)
mounted directly or via other component (any substrate or the like) on a printed circuit board, and detects current (measures a current value) flowing through a busbar (also referred to as a bus bar), which is a conductive member that penetrates through the magnetic core. For example, a vehicle such as a hybrid vehicle or an electric vehicle often employs a current detector that detects current flowing through the busbar connected to a vehicular battery.

Here, the magnetic core is a substantially ring-like element that has an inner space being a hollow portion through which the busbar penetrates. Between the disconnected opposite ends of the ring, a gap portion (a magnetic gap) is formed. Further, the magnetoelectric transducer is an element disposed at the magnetic gap of the magnetic core, to detect a magnetic flux that varies depending on the current flowing through the busbar disposed to penetrate through the hollow portion, and output a signal indicative of detecting the magnetic flux as an electric signal.

Such a current detector that is mounted on a vehicle for detecting the value of current flowing through a busbar connecting between a vehicular battery of the vehicle and a vehicular electrical component is, for example, disclosed in Patent Literature 1. In the current detector disclosed in Patent Literature 1, a magnetic core and a magnetoelectric transducer (a magnetosensitive element) are held as being housed in a shared housing, and whereby the magnetic core and the magnetoelectric transducer are handled as one unit or package having their relative position fixed (in the following, such a current detector is generally referred to as the "unit-type current detector"). Such a unitized current detector is provided with, at the housing, a busbar insertion hole that communicates with the hollow portion of the magnetic core. Having busbar inserted into the busbar insertion hole and the hollow portion of the magnetic core, the current detector is fixed (screwed) to the busbar with a fixing element such as a screw. In this state, the current detector detects the value of current flowing through the busbar. Specifically, the unit-type current detector disclosed in Patent Literature 1 includes a housing made up of a first case segment and a second case segment being capable of being separated from each other, in order to hold components such as a magnetic core and a magnetoelectric transducer structuring the current detector while having their positions set to a certain positional relationship with the insulating housing. The first case segment and the second case segment are combined so as to be integrated with each other having the magnetoelectric transducer fixed to an element mounting portion formed at the separation surface of the first case segment (a surface for joining with the second case segment). Into a groove-like core holding portion (a recessed portion) formed across the first case segment and the second case segment, the magnetic core having a magnetic gap is inserted and fixed thereto. This structure eliminates the necessity of performing the delicate work of highly accurately positioning the magnetoelectric transducer at the narrow magnetic gap of the magnetic core. Hence, the Hall effect sensor can be easily positioned at the magnetic gap of the magnetic core.

With the unit-type current detector including such a housing, normally, the magnetoelectric transducer is mounted on a printed circuit board together with a signal amplifier circuit and the like, and the printed circuit board is screwed to a screw seat provided at a portion of the housing. For example, Patent Literature 2 discloses such an example, in which a printed circuit board equipped with a magnetoelectric transducer and a magnetic core are held as being housed in a shared housing. Tightening a screw that penetrates through the printed circuit board to a screw seat provided at the housing fixes the printed circuit board to the housing.

The housing disclosed in Patent Literature 2 includes: a body case which is box-shaped with an opening; and a lid member that is attached to the body case so as to close the opening of the body case, clamping the magnetic core and the printed circuit board relative to the body case that holds the magnetic core and the printed circuit board. A through-hole for allowing a busbar to pass through is formed at the body case and the lid member. Furthermore, JP07260829, JP 2013-164288, EP 2 741 091 A1, EP 2 660 611 A1 and JP 2013-120106 disclose various current detectors.

### CITATION LIST

### PATENT LITERATURE

Patent Literature 1: Japanese Patent Application Publication No. 2009-128116
Patent Literature 2: Japanese Patent Application Publication No. 2013-101014

### SUMMARY OF THE INVENTION

### TECHNICAL PROBLEMS

However, for a current detector that includes a housing structured as described above, two components capable of being separated from each other (the first case segment and the second case segment in Patent Literature 1, the body case and the lid member in Patent Literature 2) are essential. This unfortunately necessitates an operation of combining these two components to each other, and entails increased cost due to the increase in the number of components. Furthermore, this also necessitates the housing to be great in size in order to secure the space for housing the magnetic core, the printed circuit board, and the magnetoelectric transducer. This increases the size of the overall current detector, failing to meet the practical needs such as a reduction in size of a current detector and in installation space.

Primarily, the current detector including the above-described housing has been devised in order to address an extremely troublesome operation of fixing (mounting) the magnetic core and the magnetoelectric transducer structuring the current detector while positioning them to attain certain positional relationship on a shared printed circuit board. Just a minor error in the position of the magnetoelectric transducer at a narrow magnetic gap formed between the opposite ends of the magnetic core may destabilize and reduce the current detecting function. In particular, in fixing the magnetoelectric transducer to the printed circuit board with solder in the state where the magnetoelectric transducer is positioned at the magnetic gap between the opposite ends of the magnetic core, specifically, in the state where the magnetoelectric transducer for detecting the magnetic flux in the magnetic gap stands upright independently of any support (without being supported by an appropriate jig or the like), the magnetoelectric transducer may be displaced or fall. That is, the position of the magnetoelectric transducer relative to the magnetic gap of the magnetic core may deviate from the predetermined proper position due to the fixing-with-solder process. In such an event, the magnetic field proportional to the supplied current cannot be fully obtained, resulting in poor accuracy in output voltage and poor reliability.

The present invention has been made in light of such problems, and a main object thereof is to provide a current detector achieving facilitated positioning of a magnetoelectric transducer (a magnetism-voltage conversion element that converts a magnetic field into voltage) to the magnetic gap of a magnetic core despite its being small in the number of components, with improved reliability and reduced space.

### SOLUTION TO PROBLEMS

That is, the present invention relates to a current detector that includes a magnetic core and a magnetoelectric transducer mounted on a printed circuit board, the current detector detecting current flowing through a busbar being a conductive member penetrating through a busbar insertion hole formed at the printed circuit board and an inner hollow region defined by an inner circumferential edge of the magnetic core.

The current detector of the present invention further a core holder capable of being mounted on the printed circuit board while holding a magnetic core being substantially ring-shaped and provided with a magnetic gap between its opposite ends, wherein the core holder includes a restricting projection portion that fits into the magnetic gap to restrict shifting of the magnetic core, and a protective portion formed in the restricting projection portion to hold the magnetoelectric transducer as being housed therein.

Here, the substantially ring-like magnetic core is just required to form a magnetic gap between its opposite ends, and may be substantially quadrangular cylindrical, substantially circular cylindrical, or may have other cylindrical form.

With such a current detector, in the state where the core holder is holding the magnetic core, the restricting projection portion of the core holder fits into the magnetic gap formed between the opposite ends of the magnetic core to restrict shifting of the magnetic core. Thus, the state of the magnetic core properly held by the core holder can be maintained. Further, the magnetoelectric transducer is held as being housed by the protective portion formed in the restricting projection portion. Thus, the state of the magnetoelectric transducer properly held by the core holder is maintained, having the magnetoelectric transducer protected by the protective portion. As a result, without the necessity of performing troublesome work, the magnetoelectric transducer of the magnetic core can be easily positioned at the magnetic gap through the core holder. Further, mounting such a core holder on the printed circuit board sets the relative position between the magnetic core and the magnetoelectric transducer on the shared printed circuit board to a proper relative position in which the magnetoelectric transducer is disposed at the magnetic gap of the magnetic core. This implements the highly reliable current detector being free of variations in accuracy of detecting current flowing through the busbar that penetrates through the busbar insertion hole formed at the printed circuit board and the inner hollow region defined by the inner circumferential edge of the magnetic core. Furthermore, as compared to the mode in which the mutual positioning is performed in the state where the magnetic core and the magnetoelectric transducer are housed in a housing made up of a plurality of components, the present invention is practical in view of the reduced number of components, costs, and space. Further, with the current detector of the present invention, in fixing the magnetoelectric transducer to the printed circuit board with solder in the state where the magnetoelectric transducer is positioned at the magnetic gap of the magnetic core at an upright position, the magnetoelectric transducer is held as being housed in the protective portion. This avoids any trouble that may occur when the magnetoelectric transducer is independent of any support such as an appropriate jig. That is, this avoids the magnetoelectric transducer from falling and resulting in deviation of the position of the magnetoelectric transducer from the predetermined proper position relative to the magnetic gap of the magnetic core by the fixing-with-solder process. Thus, a magnetic field being proportional to the supplied current can be fully obtained at the magnetic gap, and whereby the accuracy of the output voltage improves, contributing to improving reliability.

Further, a core holder of the present invention is applied to a current detector that detects current flowing through a busbar being a conductive member penetrating through a busbar insertion hole formed at a printed circuit board and an inner hollow region defined by an inner circumferential edge of a magnetic core. The core holder is capable of holding the magnetic core being substantially ring-like and provided with a magnetic gap between its opposite ends, and the core holder is capable of being mounted on the printed circuit board. The core holder includes a restricting projection portion that fits into the magnetic gap to restrict shifting of the magnetic core, and a protective portion that is formed in the restricting projection portion to hold the magnetoelectric transducer as being housed therein.

With such a core holder, as described above, the restricting projection portion fits into the magnetic gap formed between the opposite ends of the magnetic core to restrict shifting of the magnetic core. Thus, the properly held state of the magnetic core can be maintained. Further, the magnetoelectric transducer is held as being housed by the protective portion formed in the restricting projection portion. Thus, the properly held state of the magnetoelectric transducer can be maintained, having the magnetoelectric transducer protected by the protective portion. Accordingly, the magnetoelectric transducer can be easily positioned at the magnetic gap of the magnetic core through the core holder of the present invention. Thus, since troublesome work of positioning the magnetoelectric transducer at the magnetic gap can be eliminated, the work efficiency improves. Further, with the core holder of the present invention, the magnetoelectric transducer is held as being housed in the protective portion. Accordingly, in fixing the magnetoelectric transducer, which is positioned at the magnetic gap at an upright position, to the printed circuit board with solder, the magnetoelectric transducer is prevented from falling and deviating from the proper specified position relative to the magnetic gap. Mounting the core holder of the present invention on the printed circuit board can determine the relative position between the magnetic core and the magnetoelectric transducer on the shared printed circuit board to a proper position where the magnetoelectric transducer is disposed at the magnetic gap of the magnetic core. This implements the highly reliable current detector being capable of highly accurately detecting current flowing through the busbar penetrating through the busbar insertion hole formed at the printed circuit board and the inner hollow region defined by the inner circumferential edge of the magnetic core.

In particular, when the core holder of the present invention includes a first elastically engaging portion capable of elastically deforming and engaging with the opening edge of the busbar insertion hole when the core holder is inserted into the busbar insertion hole formed at the printed circuit board, the core holder can be mounted on the printed circuit board by allowing the first elastically engaging portion to elastically deform and engage with the opening edge of the busbar insertion hole without using any appropriate fixing element such as a screw. In addition, the busbar insertion hole is formed at the printed circuit board originally for allowing the busbar to penetrate through. Mounting the core holder using such a busbar insertion hole eliminates the necessity of providing special work or a dedicated component to the printed circuit board for mounting the core holder, and hence is preferable. Further, the first elastically engaging portion elastically engaging with the opening edge of the busbar insertion hole by the core holder being inserted into the busbar insertion hole can be released from the elastically engaged state by any appropriate operation. Accordingly, when the elastically engaged state of the first elastically engaging portion with the opening edge of the busbar insertion hole is released, the core holder can be removed from the printed circuit board. Thus, replacement or maintenance of the core holder can be easily performed.

Additionally, when the core holder of the present invention includes a second elastically engaging portion capable of elastically deforming in holding the magnetic core and capable of engaging with part of the exposed outer surface of the magnetic core not covered with other member, the process of causing the core holder to hold the magnetic core can be smoothly and easily performed using the elastic deformation of the second elastically engaging portion. In combination with the effect of the restricting projection portion fitting into the magnetic gap, the excellent held state can be maintained in which shifting of the magnetic core is restricted. Further, the second elastically engaging portion elastically engaging with part of the outer surface of the magnetic core can be released from the elastically engaged state by any appropriate operation. Accordingly, when the elastically engaged state is released, the magnetic core can be removed from the core holder. Thus, replacement or maintenance of the magnetic core and the core holder can be easily performed.

The core holder of the present invention may include an inner circumference restricting wall portion that abuts on part of the inner circumferential edge of the magnetic core to restrict shifting of the magnetic core, and an outer circumference restricting wall portion that abuts on part of an outer circumferential edge of the magnetic core to restrict shifting of the magnetic core. With such a core holder, the inner circumference restricting wall portion or the outer circumference restricting wall portion restricts shifting of the magnetic core in cooperation with the restricting projection portion fitting into the magnetic gap. Thus, the excellent held state of the magnetic core can be maintained.

### ADVANTAGEOUS EFFECTS OF INVENTION

The present invention provides a current detector, as defined by claim 1, with which a magnetoelectric transducer can be easily positioned at the magnetic gap of the magnetic core, while avoiding troublesome and high-accuracy work of directly mounting the magnetoelectric transducer and the magnetic core to the printed circuit board with the magnetoelectric transducer positioned at the magnetic gap of the magnetic core. Thus, the present invention provides the current detector, with improved current detection accuracy and reliability, which are space-saving, by being capable of setting the relative position between the magnetoelectric transducer and the magnetic core without using a housing for securing an inner space for housing the magnetoelectric transducer and the magnetic core.

### BRIEF DESCRIPTION OF THE DRAWINGS

Fig. 1 is a plan view of a predetermined portion of an inverter provided with current detectors according to an embodiment of the present invention.
Fig. 2 is a schematic diagram for describing the mounting position of the current detectors relative to a printed circuit board shown in Fig. 1.
Fig. 3 is a view on arrow A in Fig. 2.
Fig. 4 is a perspective view showing the mounted state of one current detector according to the embodiment.
Fig. 5 is an exploded perspective view of Fig. 4.
Fig. 6 is an enlarged view of Fig. 5.
Fig. 7 is a general view of the core holder according to the embodiment as seen from a direction different from Fig. 6.
Fig. 8 is a section view taken along line X-X in Fig. 2.
Fig. 9 is a section view taken along line Y-Y in Fig. 2.
Fig. 10 is a section view taken along line Z-Z in Fig. 3.

### DESCRIPTION OF EMBODIMENTS

In the following, with reference to the drawings, a description will be given of an embodiment of the present invention.

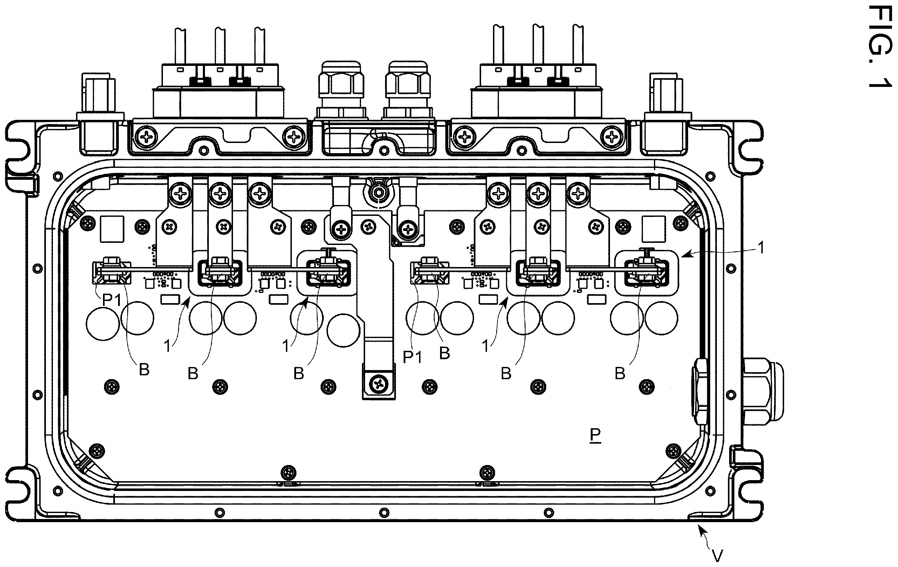

As shown in Fig. 1, current detectors 1 according to the present embodiment are capable of being mounted on, for example, a printed circuit board P which structures part of an inverter V mounted on a vehicle such as a hybrid vehicle or an electric vehicle, to each detect (measure) current flowing through a busbar B electrically connecting between a battery and an electronic device such as an EV motor. Note that, each busbar B electrically connecting between the battery and the electronic device such as a compact EV motor is a conductive member made of metal such as copper. In the inverter V according to the present embodiment, the opposite ends of the busbar B are connected to other previously installed busbars (the busbar on the battery side and the busbar on the electronic device side such as a compact EV motor), and whereby the detection-target current flows through the busbar B.

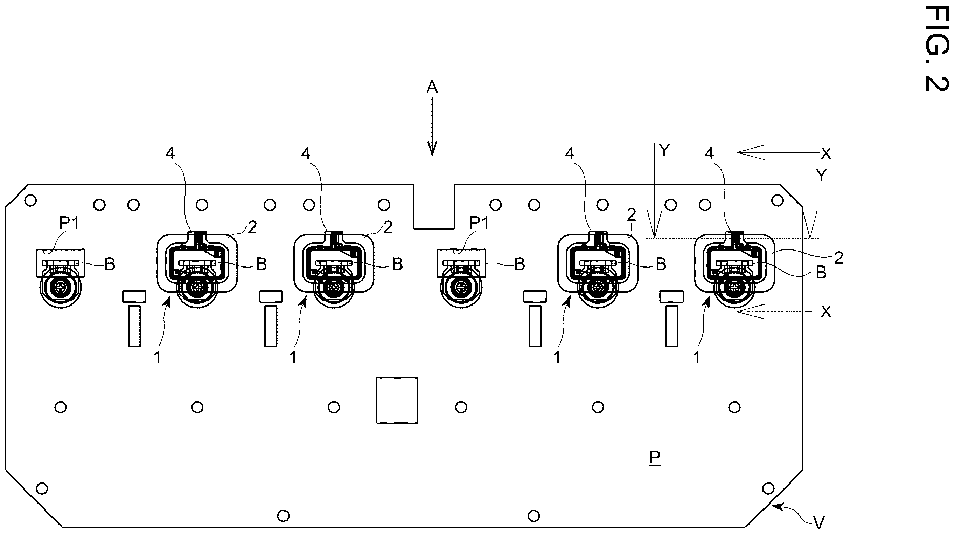

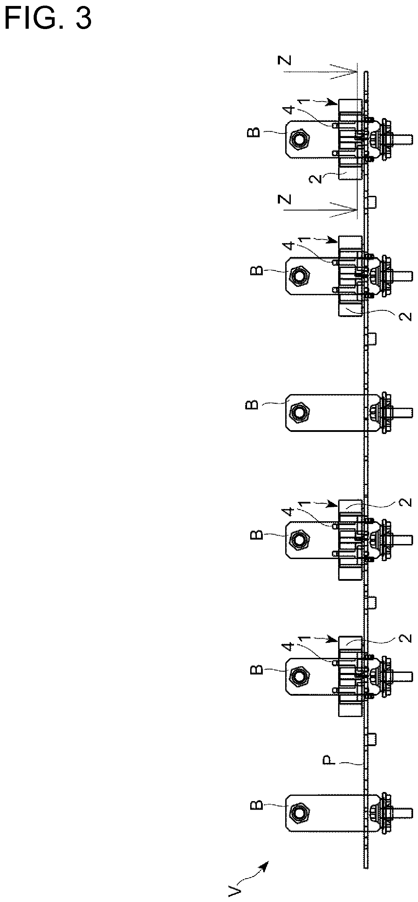

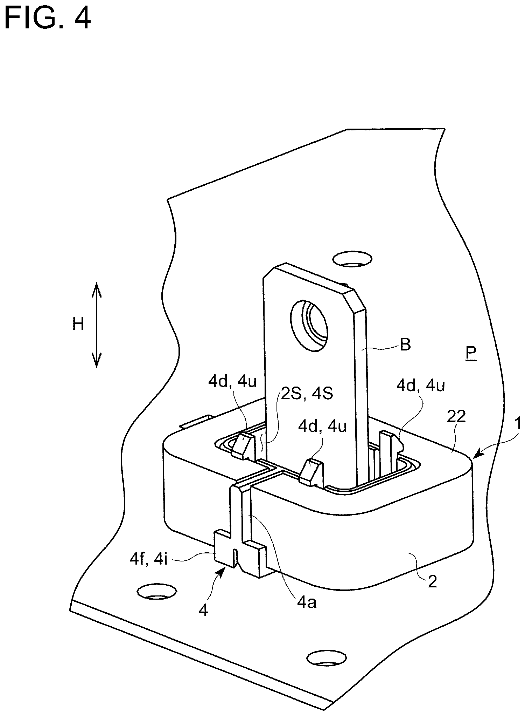

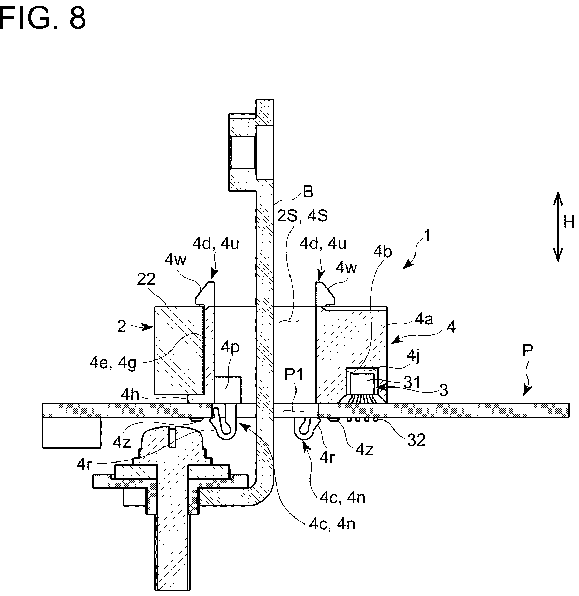

In the present embodiment, the ends (terminal portions) of the current detecting-purpose busbar B are coupled to previously installed other busbars B with screws. Fig. 1 is a plan view of a predetermined portion of the inverter V. Fig. 2, which is referred to in a later description, is a schematic diagram for describing the mounting position of the current detectors 1 relative to the printed circuit board P shown in Fig. 1. Fig. 3 is a view on arrow A in Fig. 2. Fig. 4 is a perspective view showing the mounted state of one current detector 1 relative to the printed circuit board P. Note that, while Figs. 2 and 3 have not undergone hidden-line removal, details of the main parts can be recognized in Figs. 8 to 10 which are referred to later.

In the inverter V according to the present embodiment, in order for the current detectors 1 to respectively detect current of two phases out of three-phase current output from the EV motor and flowing through the busbar B, the current detectors 1 are respectively disposed in association with predetermined busbars B (see Figs. 1 to 3). Specifically, in the inverter V according to the present embodiment, a plurality of busbar insertion holes P1 are provided to a shared printed circuit board P. The current detectors 1 are disposed on the printed circuit board P respectively in association with two busbars B through which current of predetermined two phases flows, out of the busbars B respectively penetrating through the busbar insertion holes P1.

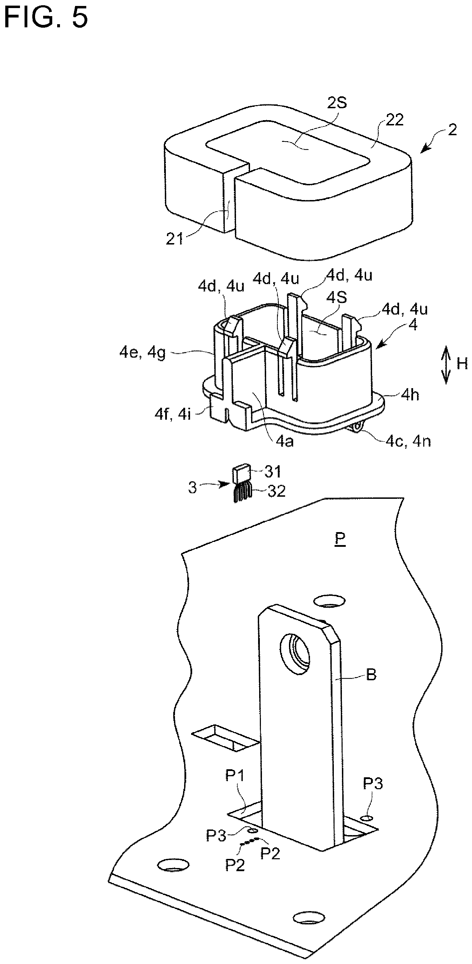

As shown in Figs. 4 and 5 (Fig. 5 is an exploded perspective view of Fig. 4), the current detectors 1 according to the present embodiment each include a magnetic core 2 and a magnetoelectric transducer 3 mounted on the printed circuit board P, and each detect current flowing through the busbar B penetrating through the busbar insertion hole P1 formed at the printed circuit board P and an inner hollow region 2S defined by the inner circumferential edge of the magnetic core 2.

The magnetic core 2 is a C-shaped ring-like magnetic element that causes the gap formed between the opposite ends to function as a magnetic gap 21. The inner hollow region 2S defined by the inner circumferential edge of the magnetic core 2 is set as the space through which the detection-target current passes (current detecting space). The busbar B penetrates through the inner hollow region 2S. The inner hollow region 2S can also be regarded as a hollow region encircled by the core portion of the magnetic core 2. In the present embodiment, the magnetic core 2 is substantially quadrangular cylindrical, having its four corners rounded.

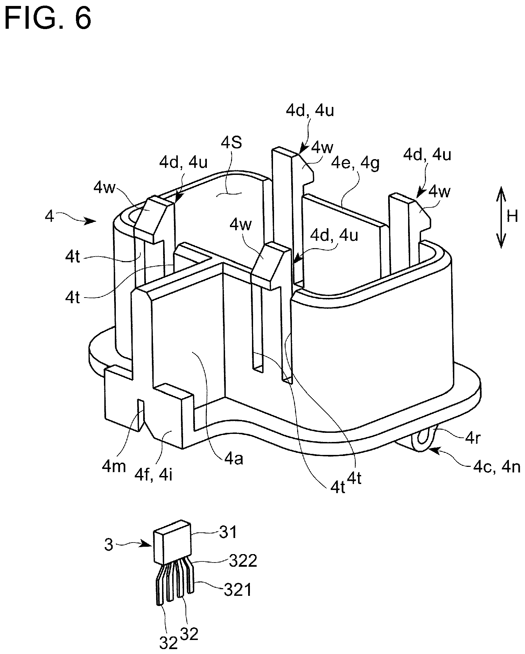

As shown in Fig. 5, the magnetoelectric transducer 3 is disposed at the magnetic gap 21 of the magnetic core 2, to detect a magnetic flux that varies depending on the current flowing through the busbar B disposed penetrating through the inner hollow region 2S of the magnetic core 2, and output a signal indicative of the detection of the magnetic flux as an electric signal. In the present embodiment, the magnetoelectric transducer 3 is a Hall effect sensor 3. As shown in Fig. 6 which is an enlarged view of Fig. 5, the Hall effect sensor 3 includes an element body 31 and terminals 32 connected to the element body 31 and also referred to as the legs. The Hall effect sensor 3 is fixed (mounted) by a soldering process to the printed circuit board P, having its terminals 32 inserted into terminal insertion holes P2 (see Fig. 5) formed at the printed circuit board P. The Hall effect sensor 3 has a plurality of (four in the drawing) terminals 32. At the lower half region of the terminals 32, straight portions 321 capable of being inserted into the terminal insertion holes P2 are formed. At the upper half region of the terminals 32, inclined portions 322 forming arbitrary angles relative to the straight portions 321 are formed. The height dimension of the inclined portions 322 determines the mounting height of the Hall effect sensor 3 relative to the printed circuit board P.

Note that, those elements mounted on the printed circuit board P include, in addition to the Hall effect sensor 3, a circuit that amplifies a signal output from the Hall effect sensor 3 indicative of detecting the magnetic flux and the like.

Here, provided that the Hall effect sensor 3 and the magnetic core 2 are individually fixed to the printed circuit board P, the fixing process may be performed in order of, for example, firstly fixing the magnetic core 2 to the printed circuit board P, and subsequently fixing the Hall effect sensor 3 to the printed circuit board P. Alternatively, the fixing process may be performed in order of firstly fixing the Hall effect sensor 3 to the printed circuit board P, and subsequently fixing the magnetic core 2 to the printed circuit board P. Whichever the operation order (work procedure) may be, the Hall effect sensor 3 and the magnetic core 2 are required to be fixed to the printed circuit board P at specified proper positions where the Hall effect sensor 3 is positioned at the magnetic gap 21. Such proper positioning of the Hall effect sensor 3 and the magnetic gap 21 requires high-accuracy work, incurring much expense in time and effort for the mounting process (the fixing process). In particular, in fixing the Hall effect sensor 3 to the printed circuit board P with solder in the state where the Hall effect sensor 3 for detecting a magnetic flux stands upright in the magnetic gap 21 independently of any support (without being supported by an appropriate jig or the like), the Hall effect sensor 3 may wobble or fall. That is, the position of the Hall effect sensor 3 relative to the magnetic gap 21 of the magnetic core 2 may deviate from the predetermined proper position in the fixing-with-solder process. In such an event, the magnetic field proportional to the supplied current cannot be fully obtained, resulting in poor accuracy in output voltage and poor reliability. Hence, the current detector 1 substantially becomes a defective article.

In light of the foregoing, the current detector 1 according to the present embodiment includes a core holder 4 that holds the magnetic core 2.

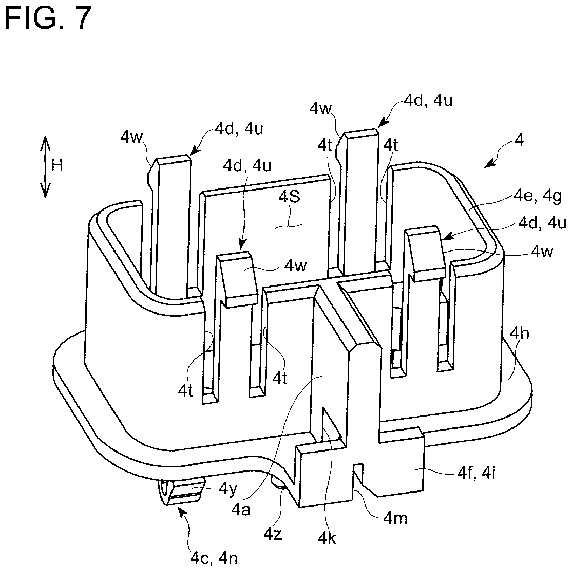

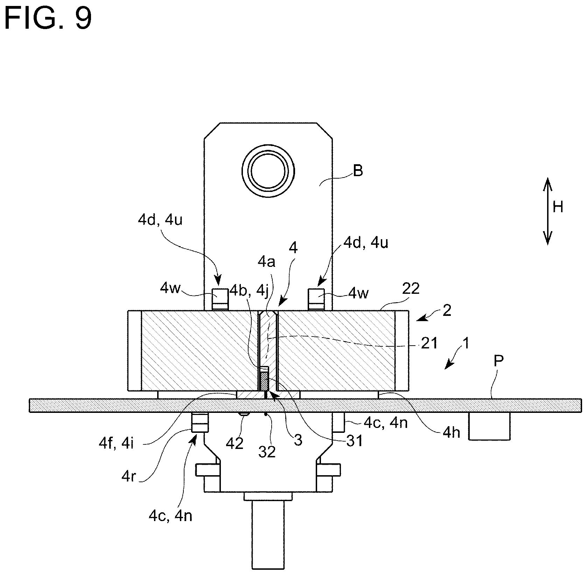

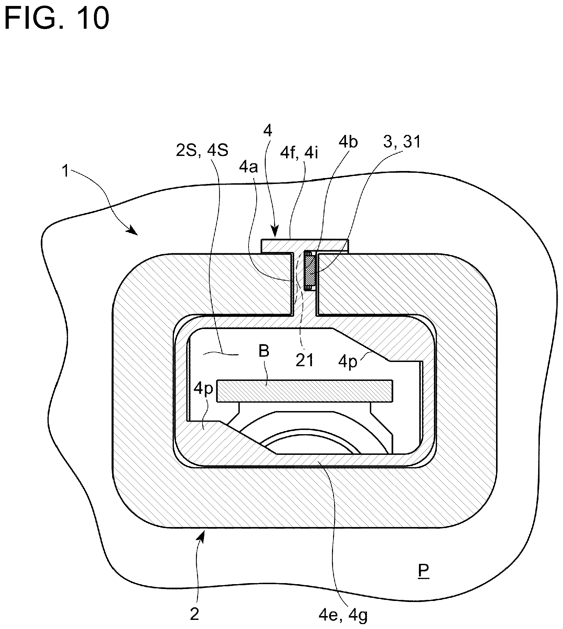

The core holder 4 is integrally formed with a resin material that highly withstands heat, for example, the high heat in the fixing-with-solder process. As shown in Figs. 4 to 10 (Fig. 7 is a general view showing the core holder 4 as seen from a direction different from Fig. 6. Fig. 8 is a section view taken along line X-X in Fig. 2. Fig. 9 is a section view taken along line Y-Y in Fig. 2. Fig. 10 is a section view taken along line Z-Z in Fig. 3), the core holder 4 includes: a restricting projection portion 4a that fits into the magnetic gap 21 to restrict shifting of the magnetic core 2; a protective portion 4b that houses and holds the Hall effect sensor 3 (see Figs. 9 and 10); a first elastically engaging portion 4c that elastically deforms when the core holder 4 is inserted into the busbar insertion hole P1 formed at the printed circuit board P, to engage with the opening edge of the busbar insertion hole P1; a second elastically engaging portion 4d that elastically deforms when the core holder 4 is caused to hold the magnetic core 2, to engage with part of the exposed outer surface of the magnetic core 2; an inner circumference restricting wall portion 4e that abuts on part of the inner circumferential edge of the magnetic core 2, to restrict shifting of the magnetic core 2; and an outer circumference restricting wall portion 4f that abuts on part of the outer circumferential edge of the magnetic core 2, to restrict shifting of the magnetic core 2.

In the following description, when the C-shaped ring-like magnetic core 2 is regarded as a cylinder, the axial direction of the cylinder is referred to as the "height direction" (the direction indicated by arrow H in Fig. 4 and others); the surface of the printed circuit board P where the current detector 1 is mounted is referred to as the upside surface, with the opposite surface being referred to as the downside surface; and the "height direction H" and the "top-bottom direction" of each component are referred to based on such principles. Note that, the current passing direction in the busbar B penetrating through the busbar insertion hole P1 is identical or substantially identical to the height direction H.

The core holder 4 is mainly structured by a substantially ring-like upright circumferential wall portion 4g, which is slightly smaller in planar dimension than the inner circumferential edge of the magnetic core 2. A flange portion 4h is formed along the entire lower end region of the upright circumferential wall portion 4g. In the state where the core holder 4 is mounted to the printed circuit board P, the flange portion 4h is in contact with the upside surface of the printed circuit board P. The core holder 4 according to the present embodiment employs the substantially quadrangular cylindrical upright circumferential wall portion 4g whose four corners are rounded, so as to be capable of holding the substantially quadrangular cylindrical magnetic core 2 whose four corners are rounded, with the magnetic core 2 being fitted externally to the core holder 4. To the core holder 4 structured in this manner, the magnetic core 2 can be attached from above so as to fit externally to the upright circumferential wall portion 4g. In this holding state, the upright circumferential wall portion 4g is housed in the inner hollow region 2S of the magnetic core 2, and the hollow region 4S of the core holder 4 encircled by the upright circumferential wall portion 4g and penetrating in the height direction H is also in the inner hollow region 2S of the magnetic core 2. Accordingly, in the state where the core holder 4 holds the magnetic core 2 also, the inner hollow region 2S of the magnetic core 2 is a region open in the height direction H. Further, in the present embodiment, the height dimension of the upright circumferential wall portion 4g is set such that the upper end of the upright circumferential wall portion 4g and the upside surface 22 of the magnetic core 2 are substantially at an identical height position in the state where the core holder 4 holds the magnetic core 2.

The restricting projection portion 4a projects from a predetermined position of the upright circumferential wall portion 4g so as to fill the gap (magnetic gap 21) between the opposite ends of the magnetic core 2 when the magnetic core 2 is held, in the direction so as to be spaced apart (outward) from the hollow region 4S, which is encircled by the upright circumferential wall portion 4g and opens through the height direction H. In the following description, the direction in which the restricting projection portion 4a projects relative to the upright circumferential wall portion 4g is referred to as the "frontward", and the direction that is perpendicular to both the front-rear direction defined thereby and the height direction H is referred to as the "right-left direction". The restricting projection portion 4a according to the present embodiment is set be identical in height dimension to the upright circumferential wall portion 4g. The dimension projecting outward (frontward) of the restricting projection portion 4a is set to be slightly greater than the dimension from the inner circumferential edge to the outer circumferential edge at the opposite ends of the magnetic core 2 (this dimension may be regarded to be identical to the thickness dimension of the core portion itself of the magnetic core 2 in the radial direction). At the lower end region of the tip portion in the projecting direction of the restricting projection portion 4a (the portion projecting most outward (frontward)), an opposing wall portion 4i opposing to the upright circumferential wall portion 4g is formed. The opposing wall portion 4i functions as an outer circumference restricting wall portion 4f that abuts on part of the outer circumferential edge of the magnetic core 2, to restrict shifting of the magnetic core 2.

In the core holder 4 according to the present embodiment, the upper end of the opposing wall portion 4i is set at the position lower than the upper end of the upright circumferential wall portion 4g. Note that, it is possible to set the upper end of the opposing wall portion 4i at the position higher than the upper end of the upright circumferential wall portion 4g, or at the identical position. The upper end of each of the upright circumferential wall portion 4g and the restricting projection portion 4a is provided with an appropriate tapered surface.

As shown in Figs. 9 and 10, the protective portion 4b is formed inside the restricting projection portion 4a, and capable of housing at least the element body 31 of the Hall effect sensor 3 as being held therein. In the present embodiment, the protective portion 4b is formed using a hollow portion 4j which is formed at the tip side region of the restricting projection portion 4a in the projecting direction and opens at least downward. By allowing the protective portion 4b to cover the Hall effect sensor 3, the element body 31 is housed in the protective portion 4b, achieving an excellent held state. In this held state, at least the straight portions 321 of the terminals 32 of the Hall effect sensor 3 are positioned lower than the flange portion 4h of the core holder 4. The core holder 4 according to the present embodiment is an integrally molded article made of resin. For the sake of convenience in removing from a mold assembly, as shown in Fig. 7, in the state where the Hall effect sensor 3 is held, the region of the protective portion 4b lower than the region where the element body 31 is housed opens in one of right and left directions (the left direction on the drawing) by a side slit portion 4k. Further, this region is also opened frontward by a front slit portion 4m.

As shown in Figs. 7 to 9, the first elastically engaging portion 4c is capable of engaging with the opening edge of the busbar insertion hole P1, and formed using an elastically deformable first elastically engaging claw 4n projecting lower than the flange portion 4h. In the present embodiment, an inwardly projecting portion 4p that projects toward the hollow region 4S (inward) encircled by the upright circumferential wall portion 4g is formed at a predetermined portion in the lower end region of the inner circumferential surface of the upright circumferential wall portion 4g (see Fig. 10), and the first elastically engaging claw 4n is caused to project downward from the downside surface of the inwardly projecting portion 4p. At the tip portion of the first elastically engaging claw 4n, a first hook portion 4r capable of engaging with the opening edge of the busbar insertion hole P1 (specifically, the downside surface of the opening edge) is formed using the elasticity of the first elastically engaging claw 4n itself. In the core holder 4 according to the present embodiment, out of the four corners of the upright circumferential wall portion 4g being substantially quadrangular cylindrical as seen in a plan view, the opposing two corners are each provided with the inwardly projecting portion 4p. The inwardly projecting portions 4p are each provided with the first elastically engaging portion 4c. Each first elastically engaging portion 4c has the projecting direction of the first hook portion 4r set so as to engage with the downside surface of the opening edge of the busbar insertion hole P1. Accordingly, in a pair of first elastically engaging portions 4c, the projecting direction of the first hook portion 4r of the one first elastically engaging portion 4c disposed relatively frontward (one first elastically engaging portion 4c relatively nearer to the restricting projection portion 4a in the present embodiment) is set frontward, and the projecting direction of the first hook portion 4r of other first elastically engaging portion 4c disposed relatively rearward is set rearward.

As shown in Figs. 4 to 9, the second elastically engaging portion 4d is capable of elastically engaging with part of the exposed outer surface of the magnetic core 2. In the present embodiment, at the position between slit portions 4t (see Figs. 6 and 7) formed at predetermined portions of the upright circumferential wall portion 4g, the second elastically engaging portion 4d is formed using an elastically deformable second elastically engaging claw 4u provided to project higher than the upper end of the upright circumferential wall portion 4g. In the core holder 4 according to the present embodiment, out of the four sides of the upright circumferential wall portion 4g being substantially quadrangular cylindrical as seen in a plan view, the opposing two sides (the long sides in the drawings) are each provided with a single or a plurality of second elastically engaging claws 4u (two for each long side in the drawings). The slit portions 4t formed at predetermined portions of the upright circumferential wall portion 4g are each formed by cutting the upright circumferential wall portion 4g downward by a predetermined dimension from the upper end of the upright circumferential wall portion 4g. The portions separated from the upright circumferential wall portion 4g by the slit portions 4t each function as the second elastically engaging claw 4u. At the tip portion (upper end) of each second elastically engaging claw 4u set at a position higher than the upper end of the upright circumferential wall portion 4g, a second hook portion 4w capable of engaging with the upside surface 22 of the outer surface of the magnetic core 2 is formed using the elasticity of the second elastically engaging claw 4u itself. Each second hook portion 4w has its projecting direction set so as to engage with the upside surface 22 of the magnetic core 2. Accordingly, out of the second elastically engaging portions 4d respectively formed at the opposing sides (the long sides in the present embodiment) of the upright circumferential wall portion 4g, the projecting direction of the second hook portion 4w of two second elastically engaging portions 4d disposed relatively frontward (two second elastically engaging portions 4d relatively nearer to the restricting projection portion 4a in the present embodiment) is set frontward, and the projecting direction of the second hook portion 4w of other two second elastically engaging portions 4d disposed relatively rearward is set rearward.

Further, in the core holder 4 according to the present embodiment, at predetermined positions of the downside surface of the flange portion 4h, guide pins 4z capable of fitting into positioning guide holes P3 formed at the printed circuit board P (see Fig. 5) are provided so as to project downward (see Figs. 7 to 9). In the present embodiment, the guide pins 4z are disposed near the first elastically engaging portions 4c.

Next, a description will be given of an exemplary procedure and effect of mounting the current detector 1 including the core holder 4 on the printed circuit board P.

Firstly, the C-shaped ring-like magnetic core 2 is inserted from above the core holder 4 into the core holder 4 so as to be held. At this time, the magnetic core 2 is inserted into the core holder 4 in the orientation in which the restricting projection portion 4a of the core holder 4 fits into the magnetic gap 21 which is a gap between the opposite ends of the magnetic core 2. In accordance with the insertion work, in the core holder 4, the second elastically engaging portions 4d abut on the downside surface of the magnetic core 2 preceding other parts. Then, the second elastically engaging portions 4d elastically deform, thereby allowing the magnetic core 2 to further shift toward the identical direction (in the direction toward the flange portion 4h of the core holder 4). At or immediately before the time point where the magnetic core 2 shifts to the position where the downside surface of the magnetic core 2 is brought into contact with or becomes close to the upside surface of the flange portion 4h of the core holder 4, the second elastically engaging portions 4d elastically recover and the second hook portions 4w provided at the tip portion engage with the upside surface 22 of the magnetic core 2. As a result, the magnetic core 2 is held by the core holder 4 with its shifting in the direction to come off from the core holder 4 being restricted, unless predetermined operational force that releases the engaged state of the second elastically engaging portions 4d is applied. Further, in this held state, as shown in Fig. 10, the restricting projection portion 4a of the core holder 4 fitting into the magnetic gap 21 of the magnetic core 2, and the outer circumferential surface of the upright circumferential wall portion 4g of the core holder 4 abutting on part of the inner circumferential edge of the magnetic core 2 restrict shifting of the magnetic core 2 in the front-rear direction and the right-left direction relative to the core holder 4. That is, in the core holder 4 according to the present embodiment, the upright circumferential wall portion 4g abuts on part of the inner circumferential edge of the magnetic core 2, thereby functioning as the inner circumference restricting wall portion 4e that restricts shifting of the magnetic core 2. Further, in the present embodiment, the opposing wall portion 4i (the outer circumference restricting wall portion 4f) of the core holder 4 abuts on or becomes close to part of the outer circumferential edge of the magnetic core 2, thereby further effectively restricting shifting of the magnetic core 2 (see Fig. 10). The above-described structure allows the core holder 4 to immovably hold the magnetic core 2. Note that, the flange portion 4h of the core holder 4 and the magnetic core 2 may be fixed to each other at the contact portion with an adhesive agent such as silicone, for example.

Next, the Hall effect sensor 3 is housed in the protective portion 4b, with the protective portion 4b of the core holder 4 covering the Hall effect sensor 3. By the Hall effect sensor 3 being housed so as to be fitted into the protective portion 4b formed inside the restricting projection portion 4a, the Hall effect sensor 3 held in the core holder 4 is positioned at the magnetic gap 21 of the magnetic core 2 as shown in Figs. 9 and 10. Thus, the core holder 4 can set the relative position between the magnetic core 2 and the Hall effect sensor 3 at a predetermined specified position. Note that, the protective portion 4b of the core holder 4 and the Hall effect sensor 3 may be fixed to each other at the contact portion with an adhesive agent such as silicone, for example.

While the description has been given of the work procedure in which the core holder 4 is caused to hold the magnetic core 2 and thereafter the core holder 4 is caused to hold the Hall effect sensor 3, it may be the work procedure in which the core holder 4 is firstly caused to hold the Hall effect sensor 3 and thereafter the core holder 4 is caused to hold the magnetic core 2.

Subsequently, the core holder 4 holding the magnetic core 2 and the Hall effect sensor 3 is inserted into the busbar insertion hole P1 formed at the printed circuit board P and fixed thereto. In accordance with this insertion work, in the core holder 4, the first elastically engaging portions 4c abut on the upside surface around the opening edge of the busbar insertion hole P1 preceding other parts. Then, the first elastically engaging portions 4c elastically deform, thereby allowing the core holder 4 to further shift toward the identical direction (the direction to be inserted into the busbar insertion hole P1). At the time point where the tip portion (lower end portion) of each of the first elastically engaging portions 4c has passed through the busbar insertion hole P1, the first elastically engaging portions 4c elastically recover, and the first hook portions 4r provided at the tip portion engage with the downside surface of the opening edge of the busbar insertion hole P1. As a result, the core holder 4 is fixed to the printed circuit board P with its shifting in the direction to come off from the printed circuit board P (the busbar insertion hole P1) being restricted, unless predetermined operational force that releases the engaged state of the first elastically engaging portions 4c is applied. Further, in the present embodiment, in the state where the core holder 4 is mounted on the printed circuit board P, the guide pins 4z provided at the downside surface of the core holder 4 fitting into the positioning guide holes P3 formed at the printed circuit board P restrict shifting of the core holder 4 in the front-rear direction and the right-left direction relative to the printed circuit board P. The above-described structure allows the core holder 4 to be immovably mounted on the printed circuit board P.

Further, in mounting the core holder 4 on the printed circuit board P, in the Hall effect sensor 3 held in the protective portion 4b of the core holder 4, the terminals 32 projecting lower than the flange portion 4h of the core holder 4 are inserted into the terminal insertion holes P2 formed at the printed circuit board P. Thereafter, by a soldering process (a process of immersing the terminals 32 exposed on the downside surface side of the printed circuit board P in a solder bath), the core holder 4 can be fixed to (mounted on) the printed circuit board P with the Hall effect sensor 3 positioned at the magnetic gap 21 at a predetermined upright position.

The foregoing procedure allows the current detector 1 to be mounted on the printed circuit board P, with the current detector 1 having the magnetic core 2 and the Hall effect sensor 3 positioned at a proper relative position and held by the core holder 4. Thus, by the busbar B being disposed to penetrate through the busbar insertion hole P1 and the region communicating with the busbar insertion hole P1, that is, to penetrate through the hollow region 4S of the core holder 4 that opens through the height direction H, and consequently to penetrate through the inner hollow region 2S of the magnetic core 2, the current detector 1 can detect current flowing through the busbar B (current flowing in the height direction H of the busbar B).

Note that, a procedure being different from the above-described procedure may be employed. That is, firstly the terminals 32 of the Hall effect sensor 3 are inserted into the terminal insertion holes P2 of the printed circuit board P. Then, the core holder 4 is inserted into the busbar insertion hole P1 of the printed circuit board P and fixed thereto, with the protective portion 4b covering the Hall effect sensor 3. Thereafter, the soldering process (a process of immersing the terminals 32 exposed on the downside surface side of the printed circuit board P in a solder bath) is performed. In this case, the process of causing the core holder 4 to hold the magnetic core 2 may be performed before or after the process of inserting core holder 4 into the busbar insertion hole PI of the printed circuit board P and fixing thereto, with the protective portion 4b covering the Hall effect sensor 3. Such a work procedure also allows the current detector 1 to be mounted on the printed circuit board P, with the current detector 1 having the magnetic core 2 and the Hall effect sensor 3 positioned at a proper relative position and held by the core holder 4. Thus, by the busbar B being disposed to penetrate through the busbar insertion hole P1 and the region communicating with the busbar insertion hole P1, that is, to penetrate through the hollow region 4S of the core holder 4 that opens through the height direction H, and consequently to penetrate through the inner hollow region 2S of the magnetic core 2, the current detector 1 can detect current flowing through the busbar B (current flowing in the height direction H of the busbar B).

As the present embodiment, such as use in a vehicle, in the application where relatively great vibrations are expected to act on the printed circuit board P and the current detector 1, the flange portion 4h of the core holder 4 and the printed circuit board P may be fixed to each other at the contact portion with an adhesive agent such as silicone, for example.

As has been described above, the current detector 1 according to the present embodiment includes the core holder 4 that holds a substantially ring-like magnetic core 2. The restricting projection portion 4a provided at the core holder 4 fits into the magnetic gap 21 formed between the opposite ends of the magnetic core 2, to restrict shifting of the magnetic core 2. Thus, the state of the magnetic core 2 properly held by the core holder 4 can be maintained. Further, the magnetoelectric transducer 3 being held as being housed in the protective portion 4b formed at a predetermined region extending upward from the bottom of the restricting projection portion 4a and opens at the bottom (the lower end) achieves to maintain the state of the magnetoelectric transducer 3 properly held by the core holder 4 with the magnetoelectric transducer 3 being protected at least covered from above. As a result, without the necessity of performing troublesome work, the magnetoelectric transducer 3 is easily positioned at the magnetic gap 21 of the magnetic core 2 through the core holder 4. Mounting such a core holder 4 on the printed circuit board P, the relative position of the magnetic core 2 and the magnetoelectric transducer 3 on the printed circuit board P can be determined at a proper relative position where the magnetoelectric transducer 3 is disposed at the magnetic gap 21 of the magnetic core 2. The performance of measuring current flowing through the busbar B penetrating through the busbar insertion hole P1 formed at the printed circuit board P and the inner hollow region 2S defined by the inner circumferential edge of the magnetic core 2 stabilizes. Thus, the highly reliable current detector 1 is obtained. Furthermore, as compared to the mode in which mutual positioning is performed in the state where the magnetic core and the magnetoelectric transducer are housed in a housing made up of a plurality of components, a reduction in the number of components, in costs, and in space is achieved. In particular, there exist current detecting apparatuses (DCCTs (DC current transformers)) in each of which a housing made up of a plurality of components houses the printed circuit board also in addition to the magnetic core and the magnetoelectric transducer. The DCCTs respectively house individual printed circuit boards in the housings. Accordingly, the DCCTs cannot employ the mode of the present embodiment in which a plurality of pairs of magnetic core 2 and magnetoelectric transducer 3 positioned at a proper relative position, i.e., the magnetoelectric transducer 3 being disposed at the magnetic gap 21 of the magnetic core 2, are mounted on a shared printed circuit board P provided with the busbar insertion holes P1.

Further, with the current detector 1 according to the present embodiment, in fixing the magnetoelectric transducer 3 to the printed circuit board P with solder in the state where the magnetoelectric transducer 3 is positioned at an upright position at the magnetic gap 21 of the magnetic core 2, the magnetoelectric transducer 3 is maintained in an excellent held state by the protective portion 4b. This prevents any trouble that may occur when the magnetoelectric transducer 3 is independent of any support such as an appropriate jig, that is, sudden positional displacement or falling of the magnetoelectric transducer 3 in the fixing-with-solder process, which results in positional deviation of the magnetoelectric transducer 3 relative to the magnetic gap 21 of the magnetic core 2 from the predetermined proper position. Further, the magnetic field proportional to the supplied current can be fully obtained at the magnetic gap 21, and consequently accuracy in output voltage and reliability improve.

As has been described above, in the core holder 4 according to the present embodiment, the restricting projection portion 4a is capable of fitting into the magnetic gap 21 formed between the opposite ends of the magnetic core 2 thereby restricting shifting of the magnetic core 2 and maintaining the properly held state of the magnetic core 2. Further, the protective portion 4b formed in the restricting projection portion 4a holds the magnetoelectric transducer 3 as being housed therein. Thus, the protective portion 4b is capable of protecting the magnetoelectric transducer 3 while maintaining the properly held state of the magnetoelectric transducer 3. Accordingly, through the core holder 4 according to the present embodiment, the magnetoelectric transducer 3 can be easily positioned at the magnetic gap 21 of the magnetic core 2. Thus, the troublesome work of positioning the magnetoelectric transducer 3 at the magnetic gap 21 can be eliminated, and whereby work efficiency improves. Further, with the core holder 4 according to the present embodiment, the magnetoelectric transducer 3 is held as being housed in the protective portion 4b. This avoids the risk of the magnetoelectric transducer 3 falling and deviating from the proper specified position relative to the magnetic gap 21 in mounting the magnetoelectric transducer 3 positioned at the magnetic gap 21 at the upright position to the printed circuit board P with solder.

In particular, the core holder 4 according to the present embodiment includes the first elastically engaging portions 4c which are capable of elastically deforming and engaging with the opening edge of the busbar insertion hole P1 when being inserted into the busbar insertion hole P1 formed at the printed circuit board P. Accordingly, without the necessity of using any fixing element such as a screw, the core holder 4 can be simply and smoothly mounted on the printed circuit board P by the first elastically engaging portions 4c elastically deforming and engaging with the opening edge of the busbar insertion hole P1. Furthermore, the busbar insertion hole P1 is originally formed at the printed circuit board P for allowing the busbar B to pass through. Such a structure of mounting the core holder 4 using the busbar insertion hole P1 is preferable in that it eliminates the necessity of providing any special work to the printed circuit board P or the necessity of providing a dedicated component for mounting the core holder 4. Further, as to the first elastically engaging portions 4c that elastically engage with the opening edge of the busbar insertion hole P1 by the core holder 4 being inserted into the busbar insertion hole P1, the elastically engaged state of the first elastically engaging portions 4c can be released by any appropriate operation. Accordingly, when the elastically engaged state of the first elastically engaging portions 4c with the opening edge of the busbar insertion hole P1 is released, the core holder 4 can be removed from the printed circuit board P. Thus, replacement or maintenance of the core holder 4 can be performed easily.

Additionally, the core holder 4 according to the present embodiment includes the second elastically engaging portions 4d that elastically deform in holding the magnetic core 2 and engage with part of the exposed outer surface of the magnetic core 2 (specifically, the upside surface 22 of the magnetic core 2). Accordingly, using the elastic deformation of the second elastically engaging portions 4d, the process of causing the core holder 4 to hold the magnetic core 2 can be smoothly and easily performed. Thus, in combination with the effect of the restricting projection portion 4a fitting into the magnetic gap 21, the excellent held state where shifting of the magnetic core 2 is restricted can be maintained. Further, the elastically engaged state of the second elastically engaging portions 4d that elastically engage with part of the outer surface of the magnetic core 2 can be released by any appropriate operation. Accordingly, when the elastically engaged state is released, the magnetic core 2 can be removed from the core holder 4. Thus, replacement or maintenance of the magnetic core 2 and the core holder 4 can be performed easily.

Thus, with the core holder 4 according to the present embodiment, the process of mounting the core holder 4 on the printed circuit board P and the process of causing the core holder 4 to hold the magnetic core 2 can be simply done by so-called snap-fit, using the elasticity of the material of the core holder 4.

Further, the core holder 4 according to the present embodiment includes the inner circumference restricting wall portion 4e that abuts on part of the inner circumferential edge of the magnetic core 2 to restrict shifting of the magnetic core 2, and the outer circumference restricting wall portion 4f that abuts on part of the outer circumferential edge of the magnetic core 2 to restrict shifting of the magnetic core 2. These restricting wall portions 4e, 4f also function to restrict sudden shifting of the magnetic core 2 relative to the core holder 4, to maintain the excellent held state of the magnetic core 2.

Note that, the present invention is not limited to the above-described embodiment. For example, as to the first elastically engaging portions and the second elastically engaging portions, the specific shape, the number, or the formation place in the core holder may be changed as appropriate. In particular, the portion with which the second elastically engaging portions can engage is just required to be part of the exposed outer surface of the magnetic core not being covered with other members. Instead of or additionally to the upside surface of the magnetic core, it may be the outer circumferential surface (upright surface) of the magnetic core.

In the present invention, the process of mounting the core holder on the printed circuit board and the process of causing the core holder to hold the magnetic core may be performed by an operation other than so-called snap-fit (for example, screwing). When such a structure is employed, it is possible to apply the core holder not having the first elastically engaging portions and the second elastically engaging portions.

Further, in the above-described embodiment, while the core holder that includes both the inner circumference restricting wall portion and the outer circumference restricting wall portion is exemplarily shown, the core holder may not include one or both of the inner circumference restricting wall portion and the outer circumference restricting wall portion. With the core holder including the inner circumference restricting wall portion, the portion of the inner circumferential edge of the magnetic core where the inner circumference restricting wall portion is brought into contact with (abuts on or become close to) may be one in number, and is preferably plural. The contact-target portion in the inner circumferential edge of the magnetic core may also be selected as appropriate. Similarly, with the core holder including the outer circumference restricting wall portion, the portion of the outer circumferential edge of the magnetic core where the outer circumference restricting wall portion is brought into contact with (abuts on or become close to) may be one in number, and is desirably plural. The contact-target portion in the outer circumferential edge of the magnetic core may also be selected as appropriate.

Still further, in the present invention, the core holder may not include the flange portion or the guide pin for positioning relative to the printed circuit board.

The magnetoelectric transducer may be any magnetoelectric transducer other than the Hall effect sensor 3 described in the embodiment.

The portion in the restricting projection portion of the core holder where the protective portion is formed can be changed as appropriate depending on the intended relative position of the magnetoelectric transducer to the magnetic gap. The position or size of the portion covered with the protective portion in the state where the magnetoelectric transducer is held by the protective portion can also be changed as appropriate.

While the foregoing embodiment shows the mode in which the magnetic core wraps the core holder in the state where core holder is holding the magnetic core, the core holder may wrap the magnetic core in the state where the core holder is holding the magnetic core.

The material and shape of the core holder can also be changed as appropriate.

Further, the current detector of the present invention, or an inverter including the current detector may be applied to (installed or mounted on) any apparatus other than a vehicle such as a hybrid vehicle or an electric vehicle.

Other specific structures of the constituents are not limited to those described in the embodiment, and may be modified in various manners within a range not deviating from the scope of the present invention, as defined by the claims.

### INDUSTRIAL APPLICABILITY

The present invention is applicable as a current detector with which positioning of a Hall effect sensor relative to the magnetic gap of the magnetic core is easily performed, and which provides improved reliability and a space-saving feature.

## Claims

1. A current detector (1) comprising a magnetic core (2) and a magnetoelectric transducer (3) mounted on a printed circuit board (P), the current detector (1) detecting current flowing through a busbar (B) being a conductive member penetrating through a busbar insertion hole (P1) formed at the printed circuit board (P) and an inner hollow region (2S) defined by an inner circumferential edge of the magnetic core (2),
a core holder (4) capable of being mounted on the printed circuit board (P) while holding the magnetic core (2) being substantially ring-like and provided with a magnetic gap (21) between its opposite ends, wherein
the core holder (4) includes a restricting projection portion (4a) that fits into the magnetic gap (21) to restrict shifting of the magnetic core (2), and a protective portion (4b) that is formed in the restricting projection portion (4a) to hold the magnetoelectric transducer (3) as being housed in the protective portion (4b), char
acterized in that
the core holder (4) further includes a first elastically engaging portion (4c) capable of elastically deforming and engaging with an opening edge of the busbar insertion hole (P1) when the core holder (4) is inserted into the busbar insertion hole (P1) formed at the printed circuit board (P),
wherein the first elastically engaging portion (4c) includes an elastically deformable first elastically engaging claw (4n) projecting lower than a flange portion (4h),
and wherein the first elastically engaging claw (4n) includes a first hook portion (4r) capable of engaging with the opening edge of the busbar insertion hole (P1), whereby the first hook portion (4r) is formed at a tip portion of the first elastically engaging claw (4n) using the elasticity of the first elastically engaging claw (4n) itself,
whereby the current detector (1) is obtainable by inserting the core holder (4) holding the magnetic core (2) and the magnetoelectric transducer (3) into the busbar insertion hole (P1) such that
at the time point where the tip portion of each of the first elastically engaging portions (4c) has passed through the busbar insertion hole (P1), the first elastically engaging portions (4c) elastically recover, and the first hook portions (4r) provided at the tip portion engage with the downside surface of the opening edge of the busbar insertion hole (P1), such that as a result, the core holder (4) is fixed to the printed circuit board (P).

2. The current detector (1) according to claim 1, wherein the core holder (4) further comprises a second elastically engaging portion (4d) capable of elastically deforming and engaging with part of an exposed outer surface of the magnetic core (2) when the core holder (4) holds the magnetic core (2).

3. The current detector (1) according to claim 1 or 2, wherein the core holder (4) further comprises an inner circumference restricting wall portion (4e) that abuts on part of an inner circumferential edge of the magnetic core (2) to restrict shifting of the magnetic core (2).

4. The current detector (1) according to any one of claims 1 to 3, wherein the core holder (4) further comprises an outer circumference restricting wall portion (4f) that abuts on part of an outer circumferential edge of the magnetic core (2) to restrict shifting of the magnetic core (2).

5. The current detector (1) according to any one of claims 1 to 4, wherein a pair of the first elastically engaging portions (4c) is provided at positions corresponding to two opposing corners of four corners of the busbar insertion hole (P1).

6. The current detector (1) according to any one of claims 1 to 5, wherein the core holder (4) includes a guide pin (4z) disposed near the first elastically engaging portions (4c), the guide pin (4z) being capable of fitting into positioning guide holes (P3) formed at the printed circuit board (P).

## Patentansprüche

1. Ein Stromdetektor (1), umfassend einen magnetischen Kern (2) und einen magnetoelektrischen Wandler (3), die auf einer Leiterplatte (P) angebracht sind, wobei der Stromdetektor (1) Strom detektiert, der durch eine Busbar (B) fließt, die ein leitfähiges Teil ist, welches durch ein Busbar - Einfügungsloch (P1) ragt, das an der Leiterplatte (P) gebildet ist, und einem inneren hohlen Bereich (2S), der durch einen innere Umfangsrand des magnetischen Kerns (2) definiert ist,
einen Kernhalter (4), der in der Lage ist, auf der Leiterplatte (P) angebracht zu werden, während er den magnetischen Kern (2) hält, der im Wesentlichen Ring - ähnlich ist und mit einem magnetischen Spalt (21) zwischen seinen entgegengesetzten Enden ausgestattet ist, worin
der Kernhalter (4) ein beschränkendes Vorbauteil (4a) beinhaltet, welches in den magnetischen Spalt (21) passt, um die Verschiebung des magnetischen Kerns (2) zu verringern, und ein schützendes Teil (4b), welches in dem beschränkenden Vorbauteil (4a) gebildet ist, um den magnetoelektrischen Wandler (3) als in dem schützenden Teil (4b) angeordnet zu halten,
dadurch charakterisiert, dass
der Kernhalter (4) weiterhin einen ersten elastisch eingreifenden Teil (4c) beinhaltet, die in der Lage ist, sich elastisch zu verformen und in einen Öffnungsrand des Busbar - Einfügungsloches (P1) einzugreifen, wenn der Kernhalter (4) in das Busbar-Einfügungsloch (P1) eingeführt wird, welches an der Leiterplatte (P) gebildet ist,
worin der erste elastisch eingreifende Teil (4c) eine elastisch verformbare erste elastisch eingreifende Kralle (4n) beinhaltet, die niedriger als ein Flanschteil (4h) herausragt,
und worin die erste elastisch eingreifende Kralle (4n) einen ersten Hakenteil (4r) beinhaltet, der in der Lage ist, in den Öffnungsrand des Busbar - Einfügungsloches (P1) einzugreifen, wobei der erste Hakenteil (4r) an einem Spitzenteil der esten elastisch eingreifenden Kralle (4n) gebildet wird, wobei die Elastizität der ersten elastisch eingreifende Kralle (4n) an sich genutzt wird,
wobei der Stromdetektor (1) erhältlich ist durch Einführen des Kernhalters (4), der den magnetischen Kern (2) hält, und des magnetoelektrischen Wandlers (3) in das Busbar - Einfügungsloch (P1), so dass
zu dem Zeitpunkt, zu dem das Spitzenteil von jeder der ersten elastisch eingreifende Teile (4c) durch das Busbar - Einfügungsloch (P1) hindurchgetreten ist, die ersten elastisch eingreifende Teile (4c) sich elastisch wiederherstellen, und die ersten Hakenteile (4r), die am Spitzenteil bereitgestellt sind, in die untere Oberfläche des Öffnungsrandes des Busbar-Einfügungsloch (P1) greifen, so dass als ein Ergebnis der Kernhalter (4) an der Leiterplatte (P) befestigt wird.

2. Der Stromdetektor (1) nach Anspruch 1, worin der Kernhalter (4) weiterhin einen zweiten elastisch eingreifenden Teil (4d) umfasst, der in der Lage ist, sich elastisch zu verformen und in einen Teil der exponierten äußeren Oberfläche des magnetischen Kerns (2) einzugreifen, wenn der Kernhalter (4) den magnetischen Kern (2) hält.

3. Der Stromdetektor (1) nach Anspruch 1 oder 2, worin der Kernhalter (4) weiterhin einen den inneren Umfang einschränkenden Wandteil (4e) umfasst, der an einen Teil eines inneren Umfangsrandes des magnetischen Kerns (2) grenzt, um die Verschiebung des magnetischen Kerns (2) einzuschränken.

4. Der Stromdetektor (1) nach irgendeinem der Ansprüche 1 bis 3, worin der Kernhalter (4) weiterhin einen den äußeren Umfang einschränkenden Wandteil (4f) umfasst, der an einen Teil des äußeren Umfangsrandes des magnetischen Kerns (2) angrenzt, um die Verschiebung des magnetischen Kerns (2) einzuschränken.

5. Der Stromdetektor (1) nach irgendeinem der Ansprüche 1 bis 4, worin ein Paar der ersten elastisch eingreifenden Teile (4c) an Positionen bereitgestellt ist, die zwei entgegengesetzten Ecken von vier Ecken des Busbar - Einfügungslochs (P1) entsprechen.

6. Der Stromdetektor (1) nach irgendeinem der Ansprüche 1 bis 5, worin der Kernhalter (4) einen Führungsstift (4z) beinhaltet, der in der Nähe der ersten elastisch eingreifenden Teile (4c) angeordnet ist, wobei der Führungsstift (4z) in de Lage ist, in positionierende Führungslöcher (P3) zu passen, die an der Leiterplatte (P) gebildet sind.

## Revendications

1. Détecteur de courant (1) comprenant un noyau magnétique (2) et un transducteur magnéto-électrique (3) monté sur une carte de circuit imprimé (P), le détecteur de courant (1) détectant du courant passant à travers une barre omnibus (B) étant un élément conducteur pénétrant à travers un trou d'insertion (P1) de barre omnibus formé au niveau de la carte de circuit imprimé (P) et d'une région creuse intérieure (2S) définie par un rebord circonférentiel intérieur du noyau magnétique (2),
un support de noyau (4) pouvant être monté sur la carte de circuit imprimé (P) tout en portant le noyau magnétique (2) ayant sensiblement la forme d'une bague et pourvu d'un entrefer magnétique (21) entre ses extrémités opposées, où
le support de noyau (4) comporte une partie de restriction en saillie (4a) qui s'ajuste dans l'entrefer magnétique (21) pour restreindre un déplacement du noyau magnétique (2), et une partie protectrice (4b) qui est formée dans la partie de restriction en saillie (4a) pour porter le transducteur magnéto-électrique (3) comme s'il était logé dans la partie protectrice (4b),
**caractérisé en ce que**
le support de noyau (4) comporte en outre une première partie d'engagement élastique (4c) pouvant se déformer de manière élastique et de s'engager avec un rebord d'ouverture du trou d'insertion (P1) de barre omnibus lorsque le support de noyau (4) est inséré dans le trou d'insertion (P1) de barre omnibus formé au niveau de la carte de circuit imprimé (P),
où la première partie d'engagement élastique (4c) comporte une première griffe d'engagement élastique (4n) déformable de manière élastique se projetant plus bas qu'une partie de bride (4h),
et où la première griffe d'engagement élastique (4n) comporte une première partie en crochet (4r) pouvant s'engager avec le rebord d'ouverture du trou d'insertion (P1) de barre omnibus, ce par quoi, la première partie en crochet (4r) est formée par une partie en pointe de la première griffe d'engagement élastique (4n) en utilisant l'élasticité de la première griffe d'engagement élastique (4n) elle-même,
ce par quoi, le détecteur de courant (1) est disponible en insérant le support de noyau (4) portant le noyau magnétique (2) et le transducteur magnéto-électrique (3) dans le trou d'insertion (P1) de barre omnibus de sorte
qu'à un point ponctuel où la partie en pointe de chacune des premières parties d'engagement élastique (4c) est passée à travers le trou d'insertion (P1) de la barre omnibus, les premières parties d'engagement élastiques (4c) se recouvrent de manière élastique, et les premières parties en crochet (4r) formées sur la partie en pointe s'engagent avec la surface du côté inférieur du rebord d'ouverture du trou d'insertion (P1) de la barre omnibus, de telle manière qu'il en résulte que le support de noyau (4) est fixé contre la carte de circuit imprimé (P).

2. Détecteur de courant (1) selon la revendication 1, dans lequel le support de noyau (4) comprend en outre une deuxième partie d'engagement élastique (4d) pouvant se déformer de manière élastique et s'engager avec une partie d'une surface extérieure exposée du noyau magnétique (2) lorsque le support de noyau (4) porte le noyau magnétique (2).

3. Détecteur de courant (1) selon la revendication 1 ou 2, dans lequel le support de noyau (4) comprend en outre une partie de paroi restreignant la circonférence interne (4e) qui est mise bout à bout en partie avec un rebord circonférentiel intérieur du noyau magnétique (2) afin de restreindre le glissement du noyau magnétique (2).

4. Détecteur de courant (1) selon l'une quelconque des revendications 1 à 3, dans lequel le support de noyau (4) comprend en outre une partie de paroi restreignant la circonférence extérieure (4f) qui est mise bout à bout en partie avec un rebord circonférentiel extérieur du noyau magnétique (2) afin de restreindre le glissement du noyau magnétique (2).

5. Détecteur de courant (1) selon l'une quelconque des revendications 1 à 4, dans lequel une paire de premières parties d'engagement élastique (4c) est placée à des positions correspondant à deux coins opposés parmi quatre coins du trou d'insertion (P1) de barre omnibus.

6. Détecteur de courant (1) selon l'une quelconque des revendications 1 à 5, dans lequel le support de noyau (4) comporte une goupille de guidage (4z) disposée près des premières parties d'engagement élastique (4c), la goupille de guidage (4z) pouvant s'ajuster dans des trous de guidage de positionnement (P3) formés sur la carte de circuit imprimé (P).
